# EUROPÄISCHE PATENTSCHRIFT

(11) **EP 2 543 084 B1**
(45) Veröffentlichungstag und Bekanntmachung des Hinweises auf die Patenterteilung: **29.04.2015**
(21) Anmeldenummer: 11712787.8
(22) Anmeldetag: 02.03.2011
(51) Int. Cl.: H01L 35/30, F28F 1/12, F28D 21/00

(54) **WÄRMETAUSCHER UND VERFAHREN ZUM HERSTELLEN EINES WÄRMELEITELEMENTES FÜR EINEN WÄRMETAUSCHER**
HEAT EXCHANGER AND METHOD OF MAKING A HEAT CONDUCTIVE ELEMENT FOR A HEAT EXCHANGER
ÉCHANGEUR DE CHALEUR ET PROCÉDÉ DE FABRICATION D'UN ÉLÉMENT THERMOCONDUCTEUR POUR UN ÉCHANGEUR DE CHALEUR

(30) Priorität: 05.03.2010 DE 102010002623
(43) Veröffentlichungstag der Anmeldung: 09.01.2013
(73) Patentinhaber: Micropatent B.V., 7609 PK Almelo (NL)
(72) Erfinder: BENKENDORF, Mike, 79110 Freiburg (DE); VOLKERT, Fritz, CH-4104 Oberwil (CH); NURNUS, Joachim, 79395 Neuenburg (DE)
(74) Vertreter: Staroske, Sandro
(86) Internationale Anmeldenummer: PCT/EP2011/053104
(87) Internationale Veröffentlichungsnummer: WO 2011/107511

(56) Entgegenhaltungen:
- EP-A1- 1 679 480
- EP-A2- 1 477 757
- DE-A1- 19 825 561
- DE-A1-102007 060 312
- DE-B- 1 215 330
- US-A- 4 420 940
- US-A- 5 837 928
- US-A1- 2006 157 102
- DATABASE WPI Week 200972 Thomson Scientific, London, GB; AN 2009-Q33098 XP002661319, -& CN 201 327 238 Y (SHANGHAI CAR GROUP CO LTD) 14. Oktober 2009 (2009-10-14)

## Beschreibung

Die Erfindung betrifft einen Wärmetauscher gemäß Anspruch 1, einen Wärmetauscher gemäß Anspruch 14 sowie ein Verfahren zum Herstellen eines Wärmeleitelementes für einen Wärmetauscher gemäß Anspruch 15.

Aus dem Stand der Technik siehe z.B. US 2006/0157102 sind Kühlvorrichtungen bekannt, die nach Art eines Wärmetauschers arbeiten und insbesondere Leitungen aufweisen, in denen ein erwärmtes Kühlmedium (z. B. eine Flüssigkeit) geführt wird, dem Wärmeenergie entzogen werden soll. Um die Wärmeabfuhr von den Leitungen und dem durch die Leitungen fließenden Kühlmedium zu erhöhen, sind z.B. Kühllamellen vorgesehen, die in thermischem Kontakt mit den Leitungen stehen. Über die Kühllamellen wird Wärme der Leitungen und des Kühlmediums an ein weiteres Medium (insbesondere Luft) geringerer Temperatur abgegeben, wobei das weitere Medium nach der Wärmeaufnahme aus der Kühlvorrichtung in die Umgebung abströmt, so dass Wärme des Kühlmediums ungenützt in die Umgebung abgegeben wird. Beispielsweise werden derartige Kühlvorrichtungen als Motorkühler in Kraftfahrzeugen verwendet.

Dass der Erfindung zugrunde liegende Problem besteht darin, einen Wärmetauscher zu schaffen, mit dem die Wärmeenergie eines Kühlmediums möglichst effizient nutzbar gemacht werden kann. Des Weiteren liegt der Erfindung das Problem zugrunde, ein Verfahren zur Herstellung eines Wärmeleitelementes für einen Wärmetauscher anzugeben, das den Aufbau eines energierückgewinnenden Wärmetauschers ermöglicht.

Diese Probleme werden durch den Wärmetauscher mit den Merkmalen des Anspruchs 1, durch den Wärmetauscher mit den Merkmalen des Anspruchs 14 bzw. durch das Verfahren mit den Merkmalen des Anspruchs 15 gelöst. Weiterbildungen der Erfindung sind in den abhängigen Ansprüchen angegeben.

Danach wird ein Wärmetauscher bereitgestellt, mit
- einer ersten und einer zweiten temperierbaren Struktur, die so beabstandet zueinander angeordnet sind, dass sich bei Erwärmen oder Kühlen der beiden temperierbaren Strukturen ein Zwischenbereich zwischen ihnen ausbildet, der eine andere Temperatur aufweist als die beiden temperierbaren Strukturen;
- einem mit der ersten und der zweiten temperierbaren Struktur in Wärmekontakt befindlichen Wärmeleitelement zum Ab- oder Zuführen von Wärme von oder zu der ersten und der zweiten temperierbaren Struktur, wobei das Wärmeleitelement
   - einen ersten, zweiten und dritten Abschnitt aus einem elektrisch leitfähigem Material aufweist, und
   - der erste und der zweite Abschnitt über ein erstes Verbindungselement aus einem ersten thermoelektrischen Material und der zweite und der dritte Abschnitt über ein zweites Verbindungselement aus einem zweiten thermoelektrischen Material, das von dem ersten thermoelektrischen Material verschieden ist, miteinander verbunden sind, und wobei
   - eine erste Seite des ersten Verbindungselementes der ersten temperierbaren Struktur und eine zweite Seite des ersten Verbindungselementes dem Zwischenbereich zugewandt ist,
   - eine erste Seite des zweiten Verbindungselementes der zweiten temperierbaren Struktur und eine zweite Seite des zweiten Verbindungselementes dem Zwischenbereich zugewandt ist,
   - der zweite Abschnitt des Wärmeleitelements einerseits mit der ersten Seite des ersten Verbindungselementes und andererseits mit der ersten Seite des zweiten Verbindungselementes verbunden ist,
   - so dass die ersten Seiten der Verbindungselemente jeweils einer anderen Temperatur ausgesetzt sind als ihre zweiten Seiten, wenn die erste und die zweite temperierbare Struktur mit erwärmt oder gekühlt werden, und das Wärmeleitelement nach Art eines Thermogenerators eine elektrische Spannung erzeugt.

Somit wird durch das Wärmeleitelement ein Thermogenerator realisiert, der unter Einwirkung eines durch die temperierbaren Strukturen und/oder durch ein erwärmtes oder gekühltes Medium, das mit den temperierbaren Strukturen in Wärmekontakt gebracht wird, erzeugten Temperaturfeldes eine elektrische Spannung erzeugt, d.h. mit dem Wärmeenergie der temperierbaren Strukturen oder eines mit diesen oder mit dem Wärmeleitelement in Kontakt befindlichen Mediums teilweise in elektrische Energie umgewandelt werden kann.

Unter dem ersten und dem zweiten "thermoelektrischen Material", aus dem die ersten und die zweiten Verbindungselemente gebildet sind, werden Materialien verstanden, die, wenn sie in Kontakt miteinander gebracht werden, einen makroskopisch messbaren thermoelektrischen Effekt (Seebeck-Effekt) hervorrufen können. Beispielsweise ist das erste und/oder das zweite thermoelektrische Material ein elektrisch leitfähiges Material (insbesondere ein Metall) oder ein Halbleiter. Konkrete Beispiele für das erste und das zweite thermoelektrische Material werden weiter unten erläutert.

Beispielsweise wird durch das Wärmeleitelement ein Kühlelement realisiert, über das Wärme von den temperierbaren Strukturen abgeführt werden kann, d.h. das Wärmeleitelement weist bei Betrieb des Wärmetauschers eine niedrigere Temperatur auf als die beiden temperierbaren Strukturen. Durch Beaufschlagen der temperierbaren Strukturen mit Wärme bildet sich demnach im Zwischenbereich zwischen den beiden erwärmbaren Strukturen eine Wärmesenke aus, d.h. der Zwischenbereich, dem die jeweils zweiten Seiten der Verbindungselemente zugewandt sind, weist eine niedrigere Temperatur auf als die beiden temperierbaren Strukturen. Beispielsweise weisen die beiden temperierbaren Strukturen zumindest näherungsweise die gleiche Temperatur auf, so dass sich ein näherungsweise symmetrisches Temperaturfeld mit einem Minimum, das sich etwa in der Mitte zwischen den beiden temperierbaren Strukturen befindet, einstellt.

In diesem Beispiel weist der durch das Wärmeleitelement des erfindungsgemäßen Wärmetauschers realisierte Thermogenerator anders als herkömmliche Thermogeneratoren nicht eine einzelne Heißseite auf, sondern gewissermaßen zwei Heißseiten, die durch die der ersten bzw. der zweiten temperierbaren Struktur zugewandten ersten Seiten der Verbindungselemente gebildet werden. Insbesondere stehen die ersten Seiten der Verbindungselemente jeweils in thermischem Kontakt mit der ersten bzw. zweiten temperierbaren Struktur. Die Kaltseite des Wärmeleitelement-Thermogenerators wird durch die zweiten Seiten der Verbindungselemente gebildet, die dem Zwischenbereich niedrigerer Temperatur zwischen den temperierbaren Strukturen zugewandt sind und jeweils mit dem Zwischenbereich in thermischen Kontakt stehen.

Es ist jedoch auch denkbar, dass der Wärmetauscher nicht dazu dient, Wärme von den temperierbaren Strukturen abzuführen, sondern umgekehrt dazu, den temperierbaren Strukturen Wärme des Wärmeleitelements zuzuführen. In diesem Fall weist das Wärmeleitelement bei Betrieb des Wärmetauschers eine höhere Temperatur auf als die beiden temperierbaren Elemente, so dass die jeweiligen ersten Seiten eine niedrigere Temperatur besitzen werden als die jeweiligen zweiten Seiten, die dem Zwischenraum zugewandt sind. Eine Anwendung eines derartigen Wärmetauschers ist z.B. ein Luftentfeuchter.

Dass die ersten Seiten der Verbindungselemente über den zweiten Abschnitt des Wärmeleitelementes "miteinander verbunden" sind, heißt nicht unbedingt, dass sie jeweils unmittelbar an den zweiten Abschnitt des Wärmeleitelementes angrenzen müssen. Es ist auch denkbar, dass zwischen den ersten Seiten und dem zweiten Abschnitt Verbindungsmittel (z. B. weitere Metallschichten) oder sonstige Materialien angeordnet sind, die z.B. dazu dienen, den elektrischen Kontaktwiderstand zwischen den Verbindungselementen und den mit ihnen verbundenen (in elektrischen Kontakt befindlichen) Bereichen des zweiten Abschnitts des Wärmeleitelementes möglichst gering zu halten.

Gemäß einer Variante der Erfindung erstreckt sich ein erster Endbereich des zweiten Abschnitts des Wärmeleitelementes zwischen der ersten Seite des ersten Verbindungselementes und der ersten temperierbaren Struktur. Gleichzeitig kann sich ein zweiter Endbereich des zweiten Abschnitts des Wärmeleitelementes zwischen der ersten Seite des zweiten Verbindungselementes und der zweiten temperierbaren Struktur erstrecken. Insbesondere ist der erste und/oder der zweite Endbereich mit der ersten Seite des ersten bzw. des zweiten Verbindungselementes verbunden, so dass über den zweiten Abschnitt des Wärmeleitelementes ein elektrischer Kontakt zwischen den ersten Seiten der Verbindungselemente besteht. Gleichzeitig sind die ersten Seiten über die Endbereiche des zweiten Abschnitts in Wärmekontakt mit der ersten bzw. der zweiten temperierbaren Struktur.

Darüber hinaus kann ein erster Endbereich des ersten Abschnitts des Wärmeleitelements mit der zweiten Seite des ersten Verbindungselements verbunden sein. Zudem kann ein erster Endbereich des dritten Abschnitts mit der zweiten Seite des zweiten Verbindungselementes verbunden sein. Es ist auch möglich, dass, wenn das Wärmeleitelement weitere über zusätzliche Verbindungselemente miteinander verbundene Abschnitte aufweist, jeweils ein zweiter Endbereich des ersten bzw. des dritten Abschnitts mit einer (zweiten) dem Zwischenraum zugewandten Seite eines dem ersten bzw. zweiten Verbindungselement benachbarten Verbindungselementes verbunden ist, so dass ein elektrischer Kontakt zwischen den zweiten Seiten benachbarter Verbindungselement besteht.

Der Wärmekontakt zwischen den zweiten Seiten der Verbindungselemente und dem Zwischenbereich anderer (z.B. niedrigerer) Temperatur entsteht beispielsweise dadurch, dass der Zwischenbereich ein im Wesentlichen luftgefüllter Raum ist, mit dem die zweiten Seiten jeweils in thermischem Kontakt stehen. Zusätzlich kann der Wärmekontakt zu dem Zwischenbereich auch über die Abschnitte des Wärmeleitelementes erfolgen, die mit den zweiten Seiten der Verbindungselemente verbunden sind.

Insbesondere verläuft das Wärmeleitelement durch den Zwischenbereich anderer Temperatur hindurch und kann insbesondere so ausgestaltet sein, dass über das Wärmeleitelement, d.h. insbesondere über die mit den zweiten Seiten der Verbindungselemente verbundenen Abschnitte des Wärmeleitelementes, Wärme von den zweiten Seiten der Verbindungselemente abgeführt oder Wärme den zweiten Seiten zugeführt wird. Hierfür ist das Wärmeleitelement insbesondere aus einem gut wärmeleitenden Material, z. B. einem Metall wie etwa Aluminium, gebildet bzw. weist zumindest ein derartiges Material auf.

In einem anderen Ausführungsbeispiel der Erfindung sind die erste und/oder die zweite temperierbare Struktur in Form einer Leitung zum Leiten eines erwärmten, zu kühlenden (oder eines gekühlten, zu erwärmenden) Mediums ausgebildet. Beispielsweise ist die Leitung rohrförmig (etwa holzylindrisch) und insbesondere aus einem Metall oder einem sonstigen gut wärmeleitenden Material ausgebildet, so dass Wärmeenergie des durch die Leitungen strömenden Mediums an die Leitung und z.B. von dieser an das Wärmeleitelement abgegeben wird. Als zu kühlendes Medium kommt insbesondere eine Kühlflüssigkeit (z.B. Wasser) infrage. Die Leitungen verlaufen zum Beispiel zumindest näherungsweise parallel zueinander.

Die Erfindung ist jedoch nicht auf die Verwendung von flüssigkeitsführenden Leitungen beschränkt. Die temperierbaren Strukturen können auch auf andere Weise ausgestaltet sein, z.B. in Form einer (massiven) Platte, auf die Wärme eines Mediums übertragen werden oder die Wärme aufnehmen kann. Beispielsweise kann die Platte mit einem Wärmereservoir thermisch verbunden sein, um aus diesem Wärme aufzunehmen und abzuleiten. Grundsätzlich können die temperierbaren Strukturen eine im Prinzip beliebige Gestalt aufweisen, die insbesondere durch den Verwendungszweck des Wärmetauschers bestimmt wird.

Darüber hinaus kann die erste und die zweite temperierbare Struktur dem Wärmeleitelement gegenüber elektrisch isoliert sein, insbesondere, um einen Kurzschluss zwischen den ersten Seiten der Verbindungselemente, die den temperierbaren Strukturen zugewandt sind, zu vermeiden. Hierbei können z.B. nur diejenigen Oberflächenabschnitte der temperierbaren Strukturen eine Isolierung aufweisen, die in Kontakt mit der Kühllamelle (insbesondere mit den ersten Seiten der Verbindungselemente) kommen. Es ist jedoch auch denkbar, dass ein größerer Oberflächenbereich der temperierbaren Elemente, z.B. nahezu ihr gesamter dem Kühleelement zugewandte Oberflächenbereich, mit einer derartigen Isolierung versehen ist.

Die elektrische Isolierung wird beispielsweise durch eine Keramik-, Oxid- und/oder Eloxidbeschichtung der ersten und/oder der zweiten temperierbaren Struktur realisiert.

Beispielsweise liegen sich die ersten und die zweiten Seiten der Verbindungselemente jeweils einander entlang einer Richtung senkrecht zur Haupterstreckungsrichtung der ersten und/ oder der zweiten temperierbaren Struktur gegenüber. Im Falle einer Leitung als "temperierbare Struktur" ist die "Haupterstreckungsrichtung" die Längsrichtung der Leitung. Es ist jedoch auch denkbar, dass die erste und/oder die zweite temperierbare Struktur nicht in Form einer Leitung, d.h. in Form eines Hohlkörpers, ausgebildet sind, sondern eine massive und dennoch länglich ausgebildete Struktur aufweisen, deren Längsachse die "Haupterstreckungsrichtung" der Struktur definiert.

Insbesondere ist das erste Verbindungselement näher an der ersten temperierbaren Struktur als das zweite Verbindungselement und das zweite Element näher an der zweiten temperierbaren Struktur als das erste Verbindungselement angeordnet. Beispielsweise besitzen die Verbindungselemente eine Ausdehnung in einer Richtung quer zur Haupterstreckungsrichtung der temperierbaren Strukturen, die geringer ist als der Abstand zwischen den temperierbaren Strukturen. Mit anderen Worten steht jeweils zwar die erste Seite der Verbindungselemente mit einer der temperierbaren Strukturen in Wärmekontakt, die zweite Seite der Verbindungselemente erreicht jedoch nicht die jeweils andere temperierbare Struktur, sondern endet im Zwischenraum niedrigerer Temperatur zwischen den temperierbaren Strukturen.

Die Verbindungselemente können jedoch eine im Prinzip beliebige Geometrie aufweisen. Beispielsweise sind sie zumindest näherungsweise kugelförmig ausgebildet, wobei die ersten und die zweiten Seiten eines Verbindungselements als Abschnitte eines Umfanges der Kugel ausgebildet sind, die sich einander entlang eines Radius der Kugel gegenüber liegen. Somit ist klar, dass die erste und die zweite "Seite" der Verbindungselemente nicht zwingend eine ebene Fläche sein muss, sondern z.B. auch ein gekrümmter Abschnitt der Verbindungselemente sein kann. In einer anderen Ausgestaltung sind die Verbindungselemente länglich ausgebildet, z. B. in Form eines Quaders oder eines Zylinders, wobei Stirnseiten des Quaders oder des Zylinders die ersten und die zweiten Seiten ausbilden.

Gemäß einer weiteren Ausbildung der Erfindung sind der erste, der zweite und/oder der dritte Abschnitt des Wärmeleitelementes zumindest teilweise unter einem Winkel zu einer Richtung quer zur Haupterstreckungsrichtung der ersten und/oder der zweiten temperierbaren Struktur orientiert. Beispielsweise verläuft der erste Abschnitt unter einem ersten Winkel, während der zweite Abschnitt unter einem zweiten, vom ersten Winkel verschiedenen Winkel geneigt ist. Insbesondere können der erste und der zweite Winkel zumindest näherungsweise den gleichen Betrag, jedoch ein andere "Vorzeichen" aufweisen, d.h. bezogen auf eine Senkrechte zur Haupterstreckungsrichtung können der eine Abschnitt in einer ersten Richtung und ein anderer Abschnitt in entgegengesetzter Richtung gegenüber der Senkrechten geneigt sein, so dass sich ein zickzackförmiger Verlauf des Wärmeleitelementes zwischen der ersten und der zweiten temperierbaren Struktur ergibt.

Insbesondere kann das Wärmeleitelement, wie weiter oben bereits erwähnt, neben den drei Abschnitten weitere elektrisch leitfähige Abschnitte aufweisen, die über zusätzliche Verbindungselemente miteinander verbunden sind. Diese weiteren Abschnitte erstrecken sich insbesondere jeweils schräg zu einer senkrecht zu der Haupterstreckungsrichtung der ersten und der zweiten temperierbaren Struktur verlaufenden Richtung, wobei sie jedoch abwechselnd in eine ersten Richtung und eine zweite, entgegengesetzte Richtung geneigt sind.

Beispielsweise sind sämtliche Verbindungselemente, d.h. die zusätzlichen Verbindungselemente und das erste und das zweite Verbindungselement, so beschaffen, dass sie - entlang der Haupterstreckung des Wärmeleitelementes betrachtet, d.h. insbesondere entlang der Haupterstreckungsrichtung der temperierbaren Strukturen betrachtet - abwechselnd das erste und das zweite thermoelektrische Material aufweisen. Gleichzeitig können die ersten Seiten der Verbindungselemente, d.h. diejenigen Seiten der Verbindungselemente, die der ersten oder der zweiten temperierbaren Struktur zugewandt sind, abwechselnd mit der ersten und der zweiten temperierbaren Struktur in Wärmekontakt stehen. Mit anderen Worten entsteht ein Wärmeleitelement mit einer Kette einer Mehrzahl elektrisch in Reihe (und thermisch parallel) geschalteter Verbindungselemente, wobei die durch das Wärmeleitelement in elektrische Energie umwandelbare Wärmeenergiemenge insbesondere von der Anzahl der Verbindungselemente abhängt.

Gemäß einer weiteren Ausgestaltung der Erfindung weist das erste thermoelektrische Material eine p-Dotierung und das zweite thermoelektrische Material eine n-Dotierung auf, d.h. es handelt sich bei dem ersten und dem zweiten thermoelektrischen Material um ein entsprechend dotiertes Halbleitermaterial, beispielsweise aus einer V-VI- oder IV-VI-Verbindung, insbesondere Bismuttellurid oder Bleiselenid. Es ist jedoch, wie bereits erwähnt, z.B. auch möglich, dass die thermoelektrischen Materialien unterschiedliche Metalle (oder andere elektrisch leitfähige Materialien) aufweisen oder aus unterschiedlichen Metallen gebildet sind.

Beispielsweise ist das erste und/oder das zweite thermoelektrische Material in Form eines Lotmaterials ausgebildet, über das der erste Abschnitt des Wärmeleitelements mit dem zweiten Abschnitt und/oder der zweite Abschnitt des Wärmeleitelemerits mit dem dritten Abschnitt verlötet sind. Ein derartiges Lotmaterial kann z. B. als thermoelektrisches Material das erwähnte Bismut oder Bismutantimonid aufweisen. Ein Verbindungselement, das Lotmaterial aufweist, ist somit in Form einer Lotstelle ausgebildet, die z.B. eine zumindest näherungsweise kugelförmige oder elliptische Kontur aufweist.

In einer anderen Ausgestaltung der Erfindung sind das erste und/oder das zweite Verbindungselement in Form einer Folie ausgebildet, die z.B. eine Metalllegierung, etwa Nickel-Chrom oder Nickel-Kupfer aufweist. Es ist natürlich auch denkbar, dass unterschiedliche Arten von Verbindungselementen miteinander kombiniert werden, z. B. kann das Wärmeleitelement sowohl Verbindungselemente in Form eines Lotmaterials als auch Verbindungselemente in Form einer Folie aufweisen.

Der erfindungsgemäße Wärmetauscher kann darüber hinaus auch Mittel (z.B. in Form eines Ventilators) zum Erzeugen eines Luftstroms aufweisen, die so ausgebildet sind, dass der erzeugte Luftstrom das Wärmeleitelement trifft und/oder durchsetzt, so dass durch den erzeugten Luftstrom Wärme von dem Wärmeleitelement abgeführt (oder dem Wärmeleitelement zugeführt) wird. Der Luftstrom kann insbesondere auch dazu beitragen, dass die zweiten Seiten der Verbindungselemente effizienter gekühlt werden, dass heißt effizienter Wärme von den zweiten Seiten, die die "Kaltseiten" der Verbindungselemente darstellen, abtransportiert wird.

Gemäß einem anderen Aspekt der Erfindung wird ein Thermogenerator bereitgestellt, mit
- einer ersten und einer zweiten temperierbaren Struktur, die so beabstandet zueinander angeordnet sind, dass sich bei Erwärmen oder Kühlen der beiden temperierbaren Strukturen zwischen ihnen ein Zwischenbereich ausbildet, der eine andere Temperatur aufweist als die beiden temperierbaren Strukturen;
- einem mit der ersten und der zweiten temperierbaren Struktur in Wärmekontakt befindlichen Wärmeleitelement zum Ab- oder Zuführen von Wärme von oder zu der ersten und der zweiten temperierbaren Struktur, wobei das Wärmeleitelement
   - einen ersten, zweiten und dritten Abschnitt aus einem elektrisch leitfähigem Material aufweist, und
   - der erste und der zweite Abschnitt über ein erstes Verbindungselement in Form eines ersten Thermogenerators und der zweite und der dritte Abschnitt über ein zweites Verbindungselement in Form eines zweiten Thermogenerators miteinander verbunden sind, und wobei
   - eine erste Seite des ersten Verbindungselementes der ersten temperierbaren Struktur und eine zweite Seite des ersten Verbindungselementes dem Zwischenbereich zugewandt ist,
   - eine erste Seite des zweiten Verbindungselementes der zweiten temperierbaren Struktur und eine zweite Seite des zweiten Verbindungselementes dem Zwischenbereich zugewandt ist,
   - der zweite Abschnitt des Wärmeleitelements einerseits mit der ersten Seite des ersten Verbindungselementes und andererseits mit der ersten Seite des zweiten Verbindungselementes verbunden ist,
   - so dass die ersten Seiten der Verbindungselemente jeweils einer höheren Temperatur ausgesetzt sind als ihre zweiten Seiten, wenn die erste und die zweite temperierbare Struktur über das Medium erwärmt oder abgekühlt werden, und der erste und der zweite Thermogenerator eine elektrische Spannung erzeugen.

Im Vergleich zu dem oben beschriebenen ersten Aspekt der Erfindung werden als Verbindungselemente anstelle des ersten und zweiten thermoelektrischen Materials komplette Thermogeneratoren eingesetzt. Die in Bezug auf den ersten Aspekt beschriebenen konstruktiven Varianten des Wärmetauschers lassen sich jedoch auf den zweiten Erfindungsaspekt übertragen.

Insbesondere werden mikrotechnologisch hergestellte Thermogeneratoren verwendet, die eine Mehrzahl von abwechselnd p- und n-dotierten Halbleiterschenkeln aufweisen. Die Halbleiterschenkeln sind elektrisch in Reihe geschaltet und bilden jeweils mit einer ersten Seite eine Heißseite und mit einer zweiten Seite eine Kaltseite des Thermogenerators aus.

Zudem weisen mikrotechnologisch hergestellte Thermogeneratoren z.B. ein erstes und ein zweites Substrat auf, das an ihren ersten bzw. zweiten Seiten, die insbesondere durch die Stirnseiten der Halbleiterschenkel gebildet werden, angeordnet sind und auf denen jeweils eine elektrisch leitfähige Beschichtung vorhanden ist, über die jeweils zwei benachbarte Seiten der Halbleiterschenkel elektrisch miteinander verbunden sind. Beispielsweise weisen derartige mikrotechnologisch hergestellte (miniaturisierte) Thermogeneratoren eine Substratfläche im Bereich von 0,5 bis 25 mm² auf, wobei ihre gesamte Höhe (senkrecht zum Substrat einschließlich der Substratdicke eines solchen Thermogenerators) zum Beispiel im Bereich von 100 µm bis 1.000 µm liegt. Allerdings sind miniaturisierte Thermogeneratoren im Prinzip aus dem Stand der Technik bekannt, so dass auf sie an dieser Stelle nicht weiter eingegangen werden soll.

Gegenüber der Verwendung eines thermoelektrischen Materials für die Verbindungselemente weist die Verwendung kompletter Thermogeneratoren u.U. den Nachteil auf, dass die Wärmekopplung der temperierbaren Strukturen an die thermoelektrisch aktiven Halbleiterschenkel über die Substrate erfolgen muss und dadurch schlechter sein kann als die Ankopplung an das thermoelektrische Material. Zudem können Verbindungselemente, die aus einem thermoelektrischen Material gebildet sind, eine höhere mechanische Stabilität aufweisen.

Die Erfindung betrifft auch einen wie oben beschrieben ausgebildeten Wärmetauscher, der in Form eines Motorkühlers eines Fahrzeugs ausgestaltet ist.

Darüber hinaus betrifft die Erfindung auch ein Verfahren zum Herstellen eines Wärmeleitelementes für einen Wärmetauscher, insbesondere für einen wie oben beschriebenen Wärmetauscher, mit den Schritten:
- Bereitstellen eines mit einer ersten und einer zweiten temperierbaren Struktur in Wärmekontakt bringbaren Wärmeleitelementes zum Ab- oder Zuführen von Wärme von oder zu der ersten und der zweiten temperierbaren Struktur;
- Bereitstellen eines elektrisch leitfähigen ersten, zweiten und dritten Abschnitts eines Wärmeleitelementes;
- Verbinden des ersten Abschnitts mit dem zweiten Abschnitt über ein erstes Verbindungselement aus einem ersten thermoelektrischen Material;
- Verbinden des zweiten mit dem dritten Abschnitt über ein zweites Verbindungselement aus einem zweiten thermoelektrischen Material, das von dem ersten thermoelektrischen Material verschieden ist.

Beispielsweise werden der erste, der zweite und der dritte Abschnitt des Wärmeleitelementes dadurch bereitgestellt, dass ein zunächst einstückiger Bereich des Wärmeleitelementes in den ersten, zweiten und dritten Abschnitt aufgetrennt wird.

Insbesondere weisen die Verbindungselemente jeweils eine erste Seite (Außenseite) auf, die nach Fertigstellen des Wärmeleitelementes einander abgewandt angeordnet und der ersten bzw. zweiten temperierbaren Struktur des Wärmetauschers zuzuwenden sind. Beispielsweise wird der zweite Abschnitt des Wärmeleitelementes so mit der ersten und der zweiten Seite des Verbindungselementes verbunden, dass ein erster Endbereich des zweiten Abschnitts des Wärmeleitelementes die erste Seite des ersten Verbindungselementes und ein zweiter Endbereich des zweiten Abschnitts des Wärmeleitelementes die erste Seite des zweiten Verbindungselementes kontaktiert.

Selbstverständlich kann das erfindungsgemäße Verfahren auch so ausgeführt werden, dass das Wärmeleitelement in mehr als drei Abschnitte aufgetrennt wird, zwischen denen dann jeweils Verbindungselemente angeordnet werden. Die Verbindungselemente weisen in diesem Fall abwechselnd das erste und das zweite thermoelektrische Material auf. Zudem werden die Verbindungselemente so positioniert, dass ihre ersten Seiten nach einem Verbinden des Wärmeleitelementes mit der ersten und der zweiten temperierbaren Struktur abwechselnd der ersten und der zweiten temperierbaren Struktur zugewandt sind.

Beispielsweise handelt es sich bei dem Wärmeleitelement um eine Kühllamelle, d.h. insbesondere um ein längliches Flächenelement mit einer im Vergleich zu seiner Länge und Breite, die die Flächenausdehnung der Lamelle bestimmen, geringen Dicke. Die Kühllamelle kann etwa eine Zickzack-Faltung, d.h. mehrere Knickstellen, aufweisen. Hier ist es möglich, dass die zickzackgefaltete Kühllamelle an ihren Knickstellen aufgetrennt und über die Verbindungselemente wieder "zusammengesetzt" wird. In einer anderen Variante wird die Kühllamelle vor dem Falten aufgetrennt und die durch das Auftrennen erzeugten Teilabschnitte über die Verbindungselemente wieder miteinander verbunden. Anschließend erfolgt eine Faltung (oder eine sonstige Formgebung) der Kühllamelle und das Verbinden der Kühllamelle mit der ersten und der zweiten Leitung.

Es wird darauf hingewiesen, dass das erfindungsgemäße Verfahren analog natürlich auch für die Verwendung kompletter Thermogeneratoren anstelle des ersten und des zweiten thermoelektrischen Materials verwendet werden kann.

Die Erfindung wird im Folgenden anhand von Ausführungsbeispielen unter Bezugnahme auf die Figuren näher erläutert. Es zeigen:
- Fig. 1: einen Wärmetauscher gemäß einem ersten Ausführungsbeispiel der Erfindung;
- Fig. 2: einen Wärmetauscher gemäß einem zweiten Ausführungsbeispiel der Erfindung; und
- Fig. 3: ein Wärmeleitelement für einen erfindungsgemäßen Wärmetauscher.

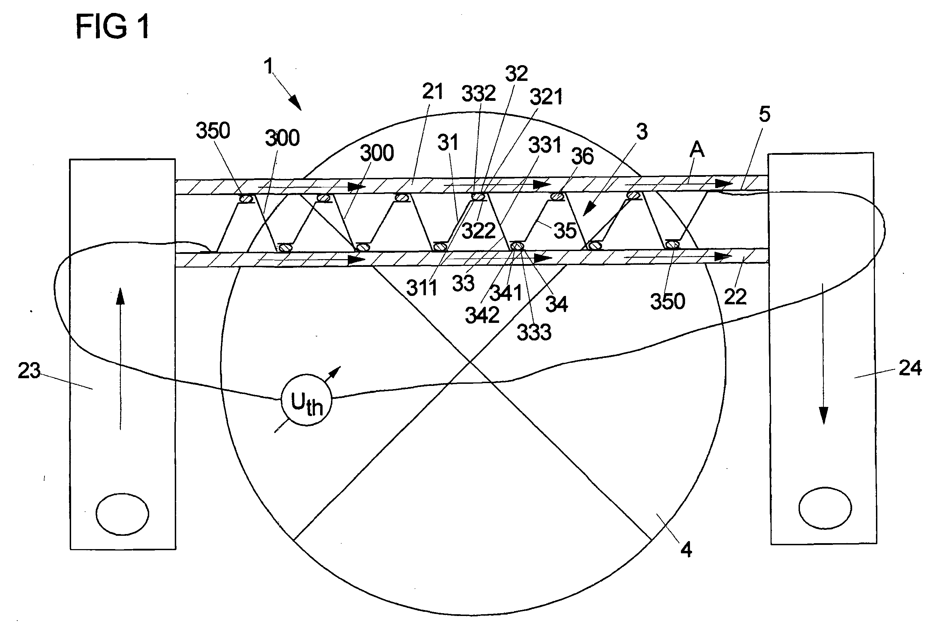

Der in Figur 1 dargestellte erfindungsgemäße Wärmetauscher 1 weist eine erste und eine zweite temperierbare Struktur in Form jeweils einer Leitung 21, 22 zum Führen eines zu kühlenden Mediums in Form von Kühlwasser 5 auf. Die Leitungen 21, 22 sind jeweils mit einem ersten Ende mit einem Kühlwassereinlass 23 verbunden, aus dem Kühlwasser in die Leitungen 21, 22 einströmt. Beispielsweise dient das Kühlwasser 5 zum Kühlen eines Motors (z.B. eines Fahrzeuges) und wird insbesondere über eine Pumpe (nicht dargestellt) in die Leitungen 21, 22 gepumpt. Ein anderes Ende der Leitungen 21, 22 ist jeweils mit einem Abfluss 24 verbunden, in dem das Wasser 5 aus den Leitungen 21, 22 einströmt.

Zwischen den beiden Leitungen 21, 22 ist ein Wärmeleitelement in Form einer zickzackförmig zwischen den Leitungen 21, 22 hin und her verlaufenden Kühllamelle 3 angeordnet. Bei Durchströmen der Leitungen 21, 22 gibt das erhitzte Kühlwasser 5, das z.B. am Kühlwassereinlass 23 eine Temperatur von 60 bis 90°C aufweist, über die Leitungen 21, 22 und die Kühllamelle 3 Wärme an die die Kühllamelle 3 umgebende Luft ab.

Die Leitungen 21, 22 sind so mit einem Abstand zueinander angeordnet, dass sich bei Durchfließen des erhitzten Kühlwassers ein Temperaturfeld im Bereich der Leitungen 21, 22 aufbaut, wobei ein Zwischenbereich zwischen den Leitungen 21, 22 entsteht, der eine niedrigere Temperatur als die Leitungen 21, 22 aufweist, zumindest, wenn die Temperatur des Zwischenraums mit der Temperatur der ersten und der zweiten Leitungen 21, 22 an der gleichen Position, in Strömungsrichtung (in Figur 1 gekennzeichnet durch Pfeile A) des Kühlwassers betrachtet, verglichen wird.

Die Kühllamelle 3 weist einen ersten elektrisch leitfähigen Abschnitt 31 auf, der über ein erstes Verbindungselement 32 mit einem zweiten elektrisch leitfähigen Abschnitt 33 der Kühllamelle 3 verbunden ist. Der zweite Abschnitt 33 ist wiederum über ein zweites Verbindungselement 34 mit einem dritten elektrisch leitfähigen Abschnitt 35 der Kühllamelle verbunden. Darüber hinaus besitzt die Kühllamelle 3 weitere Abschnitte 300 auf, die über zusätzliche Verbindungselemente 350 miteinander verbunden sind.

Das erste Verbindungselement 32 ist aus einem ersten thermoelektrischen Material ausgebildet, das zweite Verbindungselement 34 aus einem zweiten thermoelektrischen Material. Insbesondere besteht das erste Verbindungselement 32 aus einem ersten thermoelektrischen Lotmaterial, während das zweite Verbindungselement 34 aus einem von dem ersten thermoelektrischen Lotmaterial verschiedenen zweiten thermoelektrischen Lotmaterial besteht. Beispielsweise besteht das erste Verbindungselement 32 aus Bismut, während das zweite Verbindungselement 34 aus Bismutantimonid gebildet ist.

Im Ausführungsbeispiel nach Figur 1 sind das erste, zweite und dritte Verbindungselement 32, 34, 36 und auch die übrigen Verbindungselemente 300 als Lotstellen ausgeformt und besitzen daher eine im Wesentlichen kugelförmige oder elliptische Gestalt, wobei sämtliche Verbindungselemente im Wesentlichen die gleich oder zumindest eine ähnliche Form aufweisen. Dies ist natürlich nicht zwingend, sondern es ist z.B. auch möglich, dass sich die Verbindungselemente etwa in ihrem Durchmesser unterscheiden. Das erste und das zweite Verbindungselement 32, 34 weisen jeweils eine erste Seite 321, 341 auf, die der ersten bzw. der zweiten Leitung 21, 22 zugewandt sind. Insbesondere werden die ersten Seiten 321, 341 durch einen Abschnitt des Umfanges des jeweiligen Verbindungselementes 32, 34 gebildet, der z.B. auch abgeflacht gestaltet sein kann. Zweite Seiten 322, 342 der Verbindungselemente 21, 22, die jeweils ebenfalls durch einen Abschnitt des Umfanges der Verbindungselemente 32, 34 gebildet sind, liegen den ersten Seiten 321, 341 entlang einer Richtung senkrecht zur Längsrichtung der Leitungen 21, 22 gegenüber und weisen entsprechend von den Leitungen 21, 22 weg, so dass sie mit dem Zwischenraum niedrigerer Temperatur in Wärmekontakt stehen.

Somit stellen die ersten Seiten 321, 341 der Verbindungselemente, wenn die Leitungen 21, 22 von dem erwärmten Kühlwasser durchflossen werden, jeweils eine "Heißseite" der Verbindungselemente dar, während die zweiten Seiten 322, 342 der Verbindungselemente 21, 22, die dem kälteren Zwischenraum zugewandt sind, jeweils eine "Kaltseite" der Verbindungselemente 21, 22 ausbilden, die eine geringere Temperatur als die Warmseite aufweist.

Der zweite Abschnitt 33 der Kühllamelle 3 weist einen mittleren Teilabschnitt 331 auf, der gegenüber der Haupterstreckungsrichtung der Leitungen 21, 22 geneigt verläuft, während ein erster und ein zweiter Endabschnitt 332, 333 des zweiten Abschnitts 33 im Wesentlichen parallel zu den Leitungen 21, 22 ausgerichtet ist. Die parallelen Endabschnitte 332, 333 erstrecken sich zwischen den ersten Seiten 321, 341 der Verbindungselemente 32, 34 und der ersten bzw. zweiten Leitung 21, 22, wobei die Endabschnitte 332, 333 mit den ersten Seiten verbunden sind, so dass ein elektrischer Kontakt zwischen den ersten Seiten 321, 341 der Verbindungselemente 32, 34 realisiert wird.

Genauer berührt jeweils ein erster Oberflächenabschnitt der Endabschnitte 332, 333 die jeweilige erste Seite 321, 341 der Verbindungselemente 32, 34, während ein zweiter Oberflächenabschnitt der Endabschnitte 332, 333, der den Verbindungselementen 32, 34 abgewandt ist, die Außenseite der Leitung 21, 22 berührt bzw. mit dieser verbunden ist, z.B. per Punktschweißen oder stoffschlüssig mittels eines Klebers oder eines Lotmaterials.

Analog sind die zweiten Seiten 322, 342 der Verbindungselemente 21, 22 über einen Abschnitt der Kühllamelle 3 jeweils mit einer zweiten Seite, d.h. einer Seite eines Verbindungselementes, die dem Zwischenraum zu und der Leitung 21, 22 abgewandt ist, eines anderen Verbindungselementes elektrisch verbunden. Beispielsweise steht die zweite Seite 342 des zweiten Verbindungselementes 34 über den dritten Abschnitt 35 der Kühllamelle mit einem weiteren, dem zweiten Verbindungselement 34 benachbart angeordneten Verbindungselement 36 in Verbindung. Die zweite Seite 322 steht mit einem Endbereich 311 des ersten Abschnitts 31 in Kontakt.

Durch die elektrische Verbindung der Warm- und Kaltseiten benachbarter Verbindungselemente über Abschnitte der Kühllamelle bildet die Kühllamelle 3 einen Thermogenerator aus, der unter Einwirkung des Temperaturfeldes, das beim Durchfließen des erhitzten Kühlwassers 5 durch die Leitungen 21, 22 entsteht, eine elektrische Spannung generiert. Die Heißseiten des durch die Kühllamelle 3 gebildeten Thermogenerators werden, wie erwähnt, durch die jeweils der ersten bzw. der zweiten Leitung 21, 22 zugewandten ersten Seiten 332, 333 der Verbindungselemente 32, 34, während die Kaltseite durch die zweiten Seiten 322, 342 des ersten und des zweiten Verbindungselementes 32, 34'gebildet werden.

Die Leitungen 21, 22 sind zumindest an ihrer der Kühllamelle 3 zugewandten Seite jeweils mit einer elektrisch isolierenden Beschichtung bzw. mit einem elektrisch isolierenden Material versehen, um einen Kurzschluss zwischen den Verbindungselementen 32, 34, 350 zu verhindern.

Nun weist die Kühllamelle, wie oben bereits erwähnt, nicht nur drei elektrisch leitfähige Abschnitte auf, die über Verbindungselemente miteinander verbunden sind, sondern eine Vielzahl von weiteren Abschnitten 300, die jeweils über weitere Verbindungselemente 350 miteinander verbunden sind. Die weiteren Verbindungselemente 350 sind analog zu dem ersten und zweiten Verbindungselement 32, 34 abwechselnd aus dem ersten thermoelektrischen Lotmaterial und dem zweiten thermoelektrischen Lotmaterial ausgebildet, wobei abwechselnd jeweils eine erste Seite der weiteren Verbindungselemente mit der ersten und der zweiten Leitung 21, 22 in thermischen Kontakt steht. Somit sämtliche Verbindungselemente der Kühllamelle 3 elektrisch in Reihe geschaltet, so dass an den Enden der Kühllamelle eine Thermospannung Uₜₕ abgegriffen werden kann.

Der Wärmetauscher 1 aus Figur 1 weist zudem Mittel zur Erzeugung eines Luftstroms in Form eines Ventilators 4 auf, der so positioniert ist, dass ein Luftstrom entsteht, der insbesondere die Kühlelamelle 3 durchsetzt und Wärme von der Kühllamelle abführt. Dies hat insbesondere den Effekt, dass die Kaltseite des durch die Kühllamelle 3 realisierten Thermegenerators, d. h., die zweiten Seiten 322, 342 der Verbindungselemente besser gekühlt werden.

Es ist selbstverständlich auch möglich, dass der erfindungsgemäße Wärmetauscher eine Mehrzahl von Kühllamellen 3 aufweist. Beispielsweise können zusätzlich zu den in Figur 1 gezeigten Leitungen 21, 22 weitere Leitungen zwischen dem Wasserzulauf 23 und dem Wasserauslauf 24 vorgesehen sein, zwischen denen jeweils weitere Kühllamellen, die nach dem gezeigten Beispiel der Kühllamelle 3 ausgebildet sind, angeordnet sind. Beispielsweise weist ein erfindungsgemäßer Wärmetauscher 10 bis 50 Kühlwasser führende Leitungen und eine entsprechende Menge an Kühllamellen auf.

Darüber hinaus wird darauf hingewiesen, dass der Wärmetauscher der Figur 1 zwar dazu ausgebildet ist, Wärme von der ersten und der zweiten Leitung abzuführen. Es ist jedoch auch umgekehrt möglich, dass der ersten und der zweiten Leitung Wärme über die "Kühllamelle" zugeführt und diese Wärme über das die in den Leitungen fließende Flüssigkeit abtransportiert wird. Auf diese Weise kann z.B. ein Klimaanlage mit Energierückgewinnung realisiert werden.

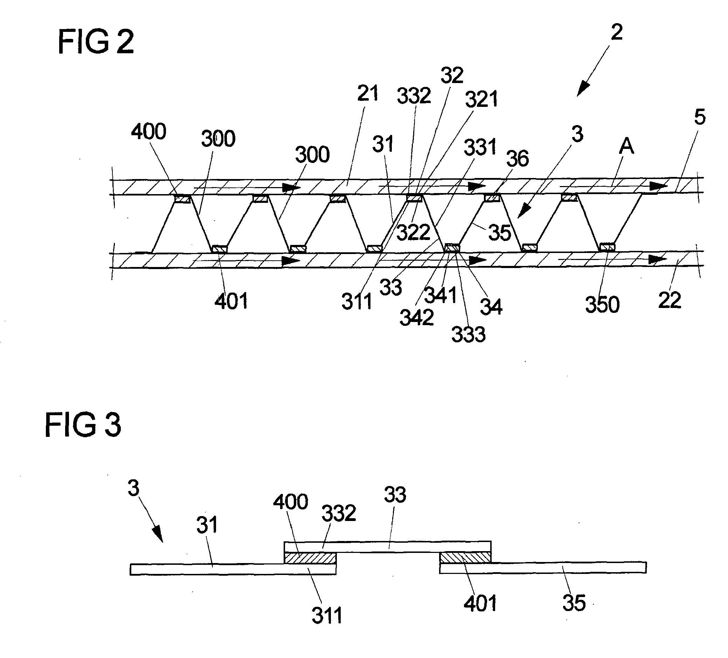

Figur 2 zeigt ein weiteres Ausführungsbeispiel des erfindungsgemäßen Wärmetauschers 1, der im Prinzip dem Wärmetauscher aus Figur 1 entspricht. Allerdings werden anstelle eines ersten und eines zweiten thermoelektrischen Lotmaterials eine erste und eine zweite Folie 400, 401 zur Realisierung der Verbindungselemente 32, 34 verwendet. Die Folien 400, 401 sind insbesondere aus unterschiedlichen Metallen oder Metalllegierungen, beispielsweise aus Nickel-Chrom bzw. Nickel-Kupfer, ausgebildet. Selbstverständlich können auch andere folienartige Materialien als erstes thermoelektrisches Material des ersten Verbindungselements und als zweites thermoelektrisches Material des zweiten Verbindungselements verwendet werden, insbesondere auch ein Schichtsystem aus mehreren Folien. Beispielsweise werden Folien verwendet, die eine Dicke im Bereich zwischen 50 µm und 200 µm, insbesondere etwa 100 µm, aufweist.

Eine Möglichkeit, eine Kühllamelle 3 für den erfindungsgemäßen Wärmetauscher herzustellen, ist in Fig. 3 illustriert, wobei ein Ausschnitt einer Kühllamelle vor ihrer Montage an den Leitungen des Wärmetauschers dargestellt ist.

Danach werden zunächst separate Abschnitte 31, 33, 35 der Kühllamelle bereitgestellt, beispielsweise dadurch, dass eine zunächst zumindest teilweise einstückige Kühllamelle aufgetrennt wird. Die Abschnitte 31, 33, 35 werden dann über erste und zweite Folien 400, 401 eines ersten bzw. eines zweiten Materials miteinander verbunden, wobei die Abschnitte 31, 33, 35 zunächst im Wesentlichen parallel zueinander ausgerichtet sind. Das Verbinden der Folien 400, 401 mit den Abschnitten 31, 33, 35 erfolgt z.B. derart, dass ein Endbereich 322 des ersten Abschnitts 31 mit einer ersten Oberfläche (z.B. mit der gesamten Oberfläche oder einem Teilbereich) und ein Endbereich 322 des zweiten Abschnitts 33 mit einer zweiten, der ersten Oberfläche abgewandten Oberfläche der ersten Folie 400 verbunden werden. Analog werden ein anderer Endbereich des zweiten Abschnitts 33 und ein Endbereich des dritten Abschnitts über die Folie 401 miteinander verbunden. Wie erwähnt, ist in Fig. 3 nur ein Ausschnitt der Kühllamelle gezeigt, wobei die gesamte Kühllamelle mehr als die gezeigten drei Abschnitte und zwei Verbindungsfolien aufweist.

Das Verbinden der Folien 400, 401 mit den Abschnitten des Wärmeleitelementes erfolgt beispielsweise über Löten, Schweißen, Laminieren oder Kleben. Nach dem Verbinden der Kühllamellenabschnitte über die Folien wird die zunächst im Wesentlichen geradlinig verlaufende Kühllamelle in die gewünschte Form gebracht, z.B. durch mehrfaches Biegen oder Falten. Insbesondere wird die Kühllamelle jeweils vor bzw. hinter den mit den Folien verbundenen Endbereichen der Kühllamellenabschnitte abgeknickt, so dass die Kühllamelle z.B. den in Fig. 2 gezeigten Zick-Zack-Verlauf erhält. Nachdem die Kühllamelle in die gewünschte Form gebracht wurde, wird diese an der ersten und der zweiten Leitung befestigt, insbesondere durch Verschweißen einiger oder sämtlicher der mit den Folien verbundenen Endbereiche der Kühllamellenabschnitte mit der ersten bzw. zweiten Leitung.

Es wird darauf hingewiesen, dass Elemente der Figuren 1 bis 3 natürlich auch miteinander kombiniert werden können, so kann z. B. ein Teil der Verbindungselemente einer Kühllamelle Verbindungselemente in Form eines Lotmaterials und gleichzeitig auch andere Verbindungselemente in Form einer Folie aufweisen. Darüber hinaus können die Verbindungselemente gemäß dem zweiten Erfindungsaspekt jeweils anstelle eines thermoelektrischen Materials oder einer thermoelektrischen Folie auch durch komplette Thermogeneratoren ausgebildet sein.

### Bezugszeichenliste

- 1: Wärmetauscher
- 3: Kühllamelle
- 4: Lüfter
- 5: Kühlwasser
- 21: erste Leitung
- 22: zweite Leitung
- 23: Wasserzulauf
- 24: Wasserablauf
- 31, 33, 35: Abschnitt Kühllamelle
- 32: erstes Verbindungselement
- 34: zweites Verbindungselement
- 36: weiteres Verbindungselement
- 300: weitere Abschnitt
- 311: Endbereich erster Abschnitt
- 321, 341: erste Seite Verbindungselement
- 322, 342: zweite Seite Verbindungselement
- 331: mittlerer Bereich zweiter Abschnitt
- 332, 333: Endbereich zweiter Abschnitt
- 350: weiteres Verbindungselement
- 400: erste Folie
- 401: zweite Folie

## Patentansprüche

1. Wärmetauscher, mit
- einer ersten und einer zweiten temperierbaren Struktur (21, 22), die so beabstandet zueinander angeordnet sind, dass sich bei Erwärmen oder Kühlen der beiden temperierbaren Strukturen (21, 22) ein Zwischenbereich zwischen ihnen ausbildet, der eine andere Temperatur aufweist als die beiden temperierbaren Strukturen (21, 22);
- einem mit der ersten und der zweiten temperierbaren Struktur (21, 22) in Wärmekontakt befindlichen Wärmeleitelement (3) zum Ab- oder Zuführen von Wärme von oder zu der ersten und der zweiten temperierbaren Struktur (21, 22), wobei das Wärmeleitelement (3)
- einen ersten, zweiten und dritten Abschnitt (31, 33, 35) aus einem elektrisch leitfähigem Material aufweist, **dadurch gekennzeichnet, dass**
- der erste und der zweite Abschnitt (31, 33) über ein erstes Verbindungselement (32) aus einem ersten thermoelektrischen Material und der zweite und der dritte Abschnitt (33, 35) über ein zweites Verbindungselement (34) aus einem zweiten thermoelektrischen Material, das von dem ersten thermoelektrischen Material verschieden ist, miteinander verbunden sind, und wobei
- eine erste Seite (321) des ersten Verbindungselementes (32) der ersten temperierbaren Struktur (21) und eine zweite Seite (322) des ersten Verbindungselementes (32) dem Zwischenbereich zugewandt ist,
- eine erste Seite (341) des zweiten Verbindungselementes (34) der zweiten temperierbaren Struktur (22) und eine zweite Seite (342) des zweiten Verbindungselementes (34) dem Zwischenbereich zugewandt ist,
- der zweite Abschnitt (33) des Wärmeleitelements einerseits mit der ersten Seite (321) des ersten Verbindungselementes (32) und andererseits mit der ersten Seite (341) des zweiten Verbindungselementes (34) verbunden ist,
- so dass die ersten Seiten (321, 341) der Verbindungselemente (32, 34) jeweils einer anderen Temperatur ausgesetzt sind als ihre zweiten Seiten (322, 342), wenn die erste und die zweite temperierbare Struktur (21, 22) mit erwärmt oder gekühlt werden, und das Wärmeleitelement (3) nach Art eines Thermogenerators eine elektrische Spannung erzeugt.

2. Wärmetauscher nach Anspruch 1, **dadurch gekennzeichnet, dass** die erste und/oder die zweite temperierbare Struktur in Form einer Leitung zum Leiten eines temperierbaren Mediums (5) ausgebildet sind.

3. Wärmetauscher nach Anspruch 2, **dadurch gekennzeichnet, dass** die erste und die zweite temperierbare Struktur (21, 22) jeweils in Form einer Leitung ausgebildet sind und die Leitungen zumindest näherungsweise parallel zueinander verlaufen.

4. Wärmetauscher nach einem der vorhergehenden Ansprüche, **dadurch gekennzeichnet, dass** sich die ersten und die zweiten Seiten (321, 341, 322, 342) der Verbindungselemente (32, 34) jeweils einander entlang einer Richtung senkrecht zur Haupterstreckungsrichtung der ersten und/oder der zweiten temperierbaren Struktur (21, 22) gegenüberliegen.

5. Wärmetauscher nach einem der vorhergehenden Ansprüche, **dadurch gekennzeichnet, dass** sich ein erstes Ende (332) des zweiten Abschnitts (33) des Wärmeleitelementes (3) zwischen der ersten Seite (321) des ersten Verbindungselementes (32) und der ersten temperierbaren Struktur (21) erstreckt und ein zweites Ende (333) des zweiten Abschnitts (33) des Wärmeleitelementes (3) zwischen der ersten Seite (341) des zweiten Verbindungselementes (34) und der zweiten temperierbaren Struktur (22).

6. Wärmetauscher nach einem der vorhergehenden Ansprüche, **dadurch gekennzeichnet, dass** das erste Verbindungselement (32) näher an der ersten temperierbaren Struktur (21) als das zweite Verbindungselement (34) angeordnet ist und das zweite Verbindungselement (34) näher an der zweiten temperierbaren Struktur (22) als das erste Verbindungselement (32).

7. Wärmetauscher nach einem der vorhergehenden Ansprüche, **dadurch gekennzeichnet, dass** der erste, der zweite und/oder der dritte Abschnitt (31, 33, 35) des Wärmeleitelementes (3) zumindest teilweise unter einem Winkel zur Haupterstreckungsrichtung der ersten und/oder zweiten temperierbaren Struktur (21, 22) orientiert ist.

8. Wärmetauscher nach einem der vorhergehenden Ansprüche, **dadurch gekennzeichnet, dass** das Wärmeleitelement (3) zickzickartig zwischen der ersten und der zweiten temperierbaren Struktur (21, 22) verläuft.

9. Wärmetauscher nach einem der vorhergehenden Ansprüche, **dadurch gekennzeichnet, dass** das Wärmeleitelement weitere Verbindungselemente (350) aufweist, über die weitere elektrisch leitfähige Abschnitte (300) des Wärmeleitelementes (3) miteinander verbunden sind, wobei sämtliche Verbindungselemente (32, 34, 350) entlang des Wärmeleitelementes (3) abwechselnd das erste und das zweite thermoelektrische Material aufweisen und die Verbindungselemente (32, 34, 350) mit einer Seite abwechselnd mit der ersten und der zweiten temperierbaren Struktur (21, 22) in Wärmekontakt stehen.

10. Wärmetauscher nach einem der vorhergehenden Ansprüche, **dadurch gekennzeichnet, dass** das erste thermoelektrische Material eine p-Dotierung und das zweite thermoelektrische Material eine n-Dotierung aufweist.

11. Wärmetauscher nach einem der vorhergehenden Ansprüche, **dadurch gekennzeichnet, dass** das erste und/oder das zweite thermoelektrische Material ein Lotmaterial ist, über das der erste Abschnitt (31) des Wärmeleitelementes (3) mit dem zweiten Abschnitt (33) des Wärmeleitelementes (3) und/oder der zweite Abschnitt (33) des Wärmeleitelementes (3) mit dem dritten Abschnitt (35) des Wärmeleitelementes (3) miteinander verlötet sind.

12. Wärmetauscher nach einem der vorhergehenden Ansprüche, **dadurch gekennzeichnet, dass** das erste und/oder das zweite Verbindungselement (32, 34) in Form einer Folie (400, 401) ausgebildet ist.

13. Wärmetauscher nach einem der vorhergehenden Ansprüche, **dadurch gekennzeichnet, dass** die erste und die zweite temperierbare Struktur (21, 22) gegenüber dem Wärmeleitelement (3) elektrisch isoliert sind.

14. Wärmetauscher, mit
- einer ersten und einer zweiten temperierbaren Struktur (21, 22), die so beabstandet zueinander angeordnet sind, dass sich bei Erwärmen oder Kühlen der beiden temperierbaren Strukturen (21, 22) zwischen ihnen ein Zwischenbereich ausbildet, der eine andere Temperatur aufweist als die beiden temperierbaren Strukturen (21, 22);
einem mit der ersten und der zweiten temperierbaren Struktur (21, 22) in Wärmekontakt befindlichen Wärmeleitelement (3) zum Ab- oder Zuführen von Wärme von oder zu der ersten und der zweiten temperierbaren Struktur (21, 22), wobei das Wärmeleitelement (3)
- einen ersten, zweiten und dritten Abschnitt (31, 33, 35) aus einem elektrisch leitfähigem Material aufweist, **dadurch gekennzeichnet, dass**
- der erste und der zweite Abschnitt (31,33) über ein erstes Verbindungselement in Form eines ersten Thermogenerators und der zweite und der dritte Abschnitt (33, 35) über ein zweites Verbindungselement in Form eines zweiten Thermogenerators miteinander verbunden sind, und wobei
- eine erste Seite (321) des ersten Verbindungselementes (32) der ersten temperierbaren Struktur (21) und eine zweite Seite (322) des ersten Verbindungselementes (32) dem Zwischenbereich zugewandt ist,
- eine erste Seite (341) des zweiten Verbindungselementes (34) der zweiten temperierbaren Struktur (22) und eine zweite Seite (342) des zweiten Verbindungselementes (34) dem Zwischenbereich zugewandt ist,
- der zweite Abschnitt (33) des Wärmeleitelements (3) einerseits mit der ersten Seite (321) des ersten Verbindungselementes (32) und andererseits mit der ersten Seite (341) des zweiten Verbindungselementes (34) verbunden ist,
- so dass die ersten Seiten (321, 341) der Verbindungselemente (32, 34) jeweils einer höheren Temperatur ausgesetzt sind als ihre zweiten Seiten, wenn die erste und die zweite temperierbare Struktur (21, 22) über das Medium erwärmt oder abgekühlt werden, und der erste und der zweite Thermogenerator eine elektrische Spannung erzeugen.

15. Verfahren zum Herstellen eines Wärmeleitelementes für einen Wärmetauscher, insbesondere gemäß einem der vorhergehenden Ansprüche, mit den Schritten:
- Bereitstellen eines mit einer ersten und einer zweiten temperierbaren Struktur (21, 22) des Wärmetauschers in Wärmekontakt bringbaren Wärmeleitelementes (3) zum Ab- oder Zuführen von Wärme von oder zu der ersten und der zweiten temperierbaren Struktur;
- Auftrennen des Wärmeleitelementes in zumindest einen elektrisch leitfähigen ersten, zweiten und dritten Abschnitt (31, 33, 35);
- Verbinden des ersten Abschnitts (31) mit dem zweiten Abschnitt (33) über ein erstes Verbindungselement (32) aus einem ersten thermoelektrischen Material;
- Verbinden des zweiten (33) mit dem dritten Abschnitt (35) über ein zweites Verbindungselement (34) aus einem zweiten thermoelektrischen Material, das von dem ersten thermoelektrischen Material verschieden ist.

## Claims

1. Heat exchanger with
- a first and a second temperature controllable structure (21, 22), which are arranged to each other with a distance such that during heating or cooling of the two temperature controllable structures (21, 22) an intermediate area is formed between them, which has a different temperature than the two temperature controllable structures (21, 22);
- a heat conductive element (3) being in heat contact with the first and the second temperature controllable structure (21, 22) for discharging or supplying heat from or to the first and the second temperature controllable structure (21, 22), wherein the heat conducting element (3) comprises
- a first, second and third section (31, 33, 35) of an electrical conductive material, **characterized in that**
- the first and the second section (31, 33) are connected to each other via a first connecting element (32) of a first thermoelectric material and the second and the third sections (33, 35) are connected to each other via a second connecting element (34) of a second thermoelectric material, which is different from the first thermoelectric material, and wherein
- a first side (321) of the first connecting element (32) of the first temperature controllable structure (21) and a second side (322) of the first connecting element (32) face the intermediate region,
- a first side (341) of the second connecting element (34) of the second temperature controllable structure (22) and a second side ( 342) of the second connecting element (34) face the intermediate region,
- the second section (33) of the heat conducting element is connected on the one hand to the first side (321) of the first connecting element (32) and on the other hand to the first side (341) of the second connecting element (34),
- such that the first sides (321, 341) of the connecting elements (32, 34) are in each case exposed to another temperature than the second sides (322, 342), if the first and the second temperature controllable structures (21, 22) are also heated or cooled and the heat conducting element (3) according to the type of the thermal generator generates an electrical voltage,

2. Heat exchanger according to claim 1, **characterized in that** the first and/or the second temperature controllable structure is formed in way of a line for conducting a temperature controllable medium (5).

3. Heat exchanger according to claim 1, **characterized in that** the first and the second temperature controllable structure (21, 22) are formed in each case in way of a line and the lines continue at least approximately parallel to each other.

4. Heat exchanger according to one of the preceding claims, **characterized in that** the first and the second sides (321, 341, 322, 342) of the connecting elements (32, 34) face each other in each case along a direction vertical to the main extension direction of the first and/or the second temperature controllable structure (21, 22).

5. Heat exchanger according to one of the preceding claims, **characterized in that** a first end (332) of the second section (33) of the heat conducting element (3) extends between the first side (321) of the first connecting element (32) and the first temperature controllable structure (21) and a second end (333) of the second section (33) of the heat conducting element (3) extends between the first side (341) of the second connecting element (34) and the second temperature controllable structure (22).

6. Heat exchanger according to one of the preceding claims, **characterized in that** the first connecting element (32) is arranged closer to the first temperature controllable structure (21) than the second connecting element (34) and the second connecting element (34) is arranged closer to the second temperature controllable structure (22) then the first connecting element (42).

7. Heat exchanger according to one of the preceding claims, **characterized in that** the first, the second and/or the third section (31, 33, 35) of the heat conducting element (3) is oriented at least partially in an angle to the main extension direction of the first and/or the second temperature controllable structure (21, 12).

8. Heat exchanger according to one of the preceding claims, **characterized in that** the heat conducting element (3) continues zig-zag-like between the first and the second temperature controllable structure (21, 22).

9. Heat exchanger according to one of the preceding claims, **characterized in that** the heat conducting element comprises further connecting elements (350) via which further electrical conducting sections (300) of the heat conducting element (3) are connected to each other, wherein all connecting elements (32, 34, 350) comprise along the heat conducting element (3) alternating the first and the second thermoelectric material and the connecting elements (32, 34, 350) are with one side in heat contact alternating with the first and the second temperature controllable structure (21, 22).

10. Heat exchanger according to one of the preceding claims, **characterized in that** the first thermoelectric material comprises a p-doping and the second thermoelectric material comprises an n-doping.

11. Heat exchanger according to one of the preceding claims, **characterized in that** the first and/or the second thermoelectric material is a solder material via which the first section (31) of the heat conducting element (3) is solded to the second section (33) of the heat conducting element (3) and/or the second section (33) of the heat conducting element (3) is solded to the third section (35) of the heat conducting element (3) to each other.

12. Heat conducting element according to one of the preceding claims, **characterized in that** the first and/or the second connecting element (32, 34) is formed in shape of a film (400, 401).

13. Heat exchanger according to one of the preceding claims, **characterized in that** the first and the second temperature controllable structure (21, 22) is electrically insulated in respect to the heat conducting element (3).

14. Heat exchanger with
- a first and a second temperature controllable structure (21, 22), which are arranged with a distance to each other such that when heating or cooling the two temperature controllable structures (21, 22) an intermediate region is formed between them, which comprises a different temperature than the two temperature controllable structures (21, 22);
- a heat conducting element (3) being in heat contact to the first and the second temperature controllable structure (21, 22) for discharging or supplying heat from or to the first and the second temperature controllable structure (21, 22), wherein the heat conducting element (3)
- comprises a first, a second and third section (31, 33, 35) of an electrical conductive material, **characterized in that**
- the first and the second section (31, 33) are connected to each other via a first connecting element in form of a first thermogenerator and the second and the third section (33, 35) are connected to each other via a second connecting element in form of a second thermogenerator, and wherein
- a first side (321) of the first connecting element (32) of the first temperature controllable structure (21) and a second side (322) of the first connecting element (32) face the intermediate region,
- a first side (341) of the second connecting element (34) of the second temperature controllable structure (22) and a second side (342) of the second connecting element (34) face the intermediate region,
- the second section (33) of the heat conducting element (3) is connected on the one hand to the first side (321) of the first connecting element (32) and is connected on the other hand to the first side (341) of the second connecting element (34),
- such that the first sides (321, 341) of the connecting elements (32, 34) are exposed in each case to a higher temperature than their second sides, if the first and the second temperature controllable structure (21, 22) are heated or cooled by the medium, and the first and the second thermogenerator generate an electrical voltage.

15. Method for producing a heat conducting element for a heat exchanger, in particular according to one of the preceding claims, with the steps:
- providing a heat conducting element (3), which can be brought into heat contact with a first and a second temperature controllable structure (21, 22) of the heat exchanger, for discharging or supplying heat from or to the first and the second temperature controllable structure
- separating the heat conducting element in at least one electrical conductive first, second and third section (31, 333, 35);
- connecting the first section (31) to the second section (33) via a first connecting element (32) of a first thermoelectric material;
- connecting the second (33) to the third section (35) via a second connecting element (34) of a second thermoelectric material, which is different from the first thermoelectric material.

## Revendications

1. Echangeur de chaleur comprenant
- une première et une deuxième structure thermorégulable (21, 22), lesquelles sont disposées de manière espacée l'une de l'autre de telle manière que lors du réchauffement ou du refroidissement des deux structures thermorégulables (21, 22), une zone intermédiaire se forme entre elles, laquelle présente une température autre que les deux structures thermorégulables (21, 22),
- un élément thermoconducteur (3) se trouvant en contact thermique avec la première structure et la deuxième structure thermorégulable (21, 22), servant à évacuer ou à amener de la chaleur de ou vers la première et la deuxième structure thermorégulable (21, 22), sachant que l'élément thermoconducteur (3)
- présente une première, une deuxième et une troisième section (31, 33, 35) constituées d'un matériau électroconducteur, **caractérisé en ce que**
- la première section et la deuxième section (31, 33) sont reliées entre elles par l'intermédiaire d'un premier élément d'assemblage (32) constitué d'un premier matériau thermoélectrique, et **en ce que** la deuxième section et la troisième section (33, 35) sont reliées entre elles par l'intermédiaire d'un deuxième élément d'assemblage (34) constitué d'un deuxième matériau, thermoélectrique, qui est différent du premier matériau thermoélectrique, et sachant
- qu'un premier côté (321) du premier élément d'assemblage (32) est tourné vers la première structure thermorégulable (21) et qu'un deuxième côté (322) du premier élément d'assemblage (32) est tourné vers la zone intermédiaire,
- qu'un premier côté (341) du deuxième élément d'assemblage (34) est tourné vers la deuxième structure thermorégulable (22) et qu'un deuxième côté (342) du deuxième élément d'assemblage (34) est tourné vers la zone intermédiaire,
- que la deuxième section (33) de l'élément thermoconducteur est reliée d'une part au premier côté (321) du premier élément d'assemblage (32) et d'autre part au premier côté (341) du deuxième élément d'assemblage (34),
- de sorte que les premiers côtés (321, 341) des éléments d'assemblage (32, 34) sont exposés respectivement à une température autre que ses deuxièmes côtés (322, 342), lorsque la première et la deuxième structure thermorégulable (21, 22) sont réchauffées ou refroidies ensemble et que l'élément thermoconducteur (3) produit une tension électrique à la manière d'un thermogénérateur.

2. Echangeur de chaleur selon la revendication 1, **caractérisé en ce que** la première structure thermorégulable et/ou la deuxième structure thermorégulable sont réalisées sous la forme d'une conduite servant à acheminer un milieu (5) thermorégulable.

3. Echangeur de chaleur selon la revendication 2, **caractérisé en ce que** la première structure thermorégulable et la deuxième structure thermorégulable (21, 22) sont réalisées respectivement sous la forme d'une conduite, et **en ce que** les conduites s'étendent au moins approximativement de manière parallèle l'une par rapport à l'autre.

4. Echangeur de chaleur selon l'une quelconque des revendications précédentes, **caractérisé en ce que** les premiers côtés et les deuxièmes côtés (321, 341, 322, 342) des éléments d'assemblage (32, 34) se font respectivement face les uns les autres le long d'une direction de manière perpendiculaire par rapport à la direction d'extension principale de la première et/ou de la deuxième structure thermorégulable (21,22).

5. Echangeur de chaleur selon l'une quelconque des revendications précédentes, **caractérisé en ce qu'**une première extrémité (332) de la deuxième section (33) de l'élément thermoconducteur (3) s'étend entre le premier côté (321) du premier élément d'assemblage (32) et la première structure thermorégulable (21), et **en ce qu'**une deuxième extrémité (333) de la deuxième section (33) de l'élément thermoconducteur (3) s'étend entre le premier côté (341) du deuxième élément d'assemblage (34) et la deuxième structure thermorégulable (22).

6. Echangeur de chaleur selon l'une quelconque des revendications précédentes, **caractérisé en ce que** le premier élément d'assemblage (32) est disposé plus à proximité de la première structure thermorégulable (21) que le deuxième élément d'assemblage (34), et **en ce que** le deuxième élément d'assemblage (34) est disposé plus à proximité de la deuxième structure thermorégulable (22) que le premier élément d'assemblage (32).

7. Echangeur de chaleur selon l'une quelconque des revendications précédentes, **caractérisé en ce que** la première, la deuxième et/ou la troisième section (31, 33, 35) de l'élément thermoconducteur (3) sont orientées au moins en partie selon un angle par rapport à la direction d'extension principale de la première et/ou de la deuxième structure thermorégulable (21, 22).

8. Echangeur de chaleur selon l'une quelconque des revendications précédentes, **caractérisé en ce que** l'élément thermoconducteur (3) s'étend à la manière d'un zigzag entre la première et la deuxième structure thermorégulable (21, 22).

9. Echangeur de chaleur selon l'une quelconque des revendications précédentes, **caractérisé en ce que** l'élément thermoconducteur présente des éléments d'assemblage (350) supplémentaires, par l'intermédiaire desquels d'autres sections (300) électroconductrices de l'élément thermoconducteur (3) sont reliées les unes aux autres, sachant que tous les éléments d'assemblage (32, 34, 350) présentent le long de l'élément thermoconducteur (3) en alternance le premier et le deuxième matériau thermoélectrique et que les éléments d'assemblage (32, 34, 350) sont en contact thermique par un côté, en alternance avec la première et la deuxième structure thermorégulable (21, 22).

10. Echangeur de chaleur selon l'une quelconque des revendications précédentes, **caractérisé en ce que** le premier matériau thermoélectrique présente un dopage p et le deuxième matériau thermoélectrique présente un dopage n.

11. Echangeur de chaleur selon l'une quelconque des revendications précédentes, **caractérisé en ce que** le premier et/ou le deuxième matériau thermoélectrique est un matériau de brasure, par l'intermédiaire duquel la première section (31) de l'élément thermoconducteur (3) est soudée à la deuxième section (33) de l'élément thermoconducteur (3) et/ou la deuxième section (33) de l'élément thermoconducteur (3) est soudée à la troisième section (35) de l'élément thermoconducteur (3).

12. Echangeur de chaleur selon l'une quelconque des revendications précédentes, **caractérisé en ce que** le premier et/ou le deuxième élément d'assemblage (32, 34) sont réalisés à la manière d'un film (400, 401).

13. Echangeur de chaleur selon l'une quelconque des revendications précédentes, **caractérisé en ce que** la première et la deuxième structure thermorégulable (21, 22) sont isolées électriquement par rapport à l'élément thermoconducteur (3).

14. Echangeur de chaleur, comprenant :
- une première et une deuxième structure thermorégulable (21, 22), lesquelles sont disposées de manière espacée l'une de l'autre de sorte que lors du réchauffement ou du refroidissement des deux structures thermorégulables (21, 22), un espace intermédiaire se forme entre elles, lequel présente une température autre que les deux structures thermorégulables (21, 22) ;
un élément thermoconducteur (3) se trouvant en contact thermique avec la première et la deuxième structure thermorégulable (21, 22), servant à évacuer ou à amener de la chaleur de ou vers la première et la deuxième structure thermorégulable (21, 22), sachant que l'élément thermoconducteur (3)
- présente une première, une deuxième et une troisième section (31, 33, 35) constituées d'un matériau électroconducteur, **caractérisé en ce que**
- la première et la deuxième section (31, 33) sont reliées entre elles par l'intermédiaire d'un premier élément d'assemblage sous la forme d'un premier thermogénérateur, et **en ce que** la deuxième et la troisième section (33, 35) sont reliées entre elles par l'intermédiaire d'un deuxième élément d'assemblage sous la forme d'un deuxième thermogénérateur, et sachant
- qu'un premier côté (321) du premier élément d'assemblage (32) est tourné vers la première structure thermorégulable (21) et qu'un deuxième côté (322) du premier élément d'assemblage (32) est tourné vers la zone intermédiaire,
- qu'un premier côté (341) du deuxième élément d'assemblage (34) est tourné vers la deuxième structure thermorégulable (22) et qu'un deuxième côté (342) du deuxième élément d'assemblage (34) est tourné vers la zone intermédiaire,
- que la deuxième section (33) de l'élément thermoconducteur (3) est reliée d'une part au premier côté (321) du premier élément d'assemblage (32) et d'autre part au premier côté (341) du deuxième élément d'assemblage (34),
- de sorte que les premiers côtés (321, 341) des éléments d'assemblage (32, 34) sont exposés respectivement à une température plus élevée que leurs deuxièmes côtés, lorsque la première et la deuxième structure thermorégulable (21, 22) sont réchauffées ou refroidies par l'intermédiaire du milieu, et que le premier et le deuxième thermogénérateur produisent une tension électrique.

15. Procédé servant à fabriquer un élément thermoconducteur pour un échangeur de chaleur, en particulier selon l'une quelconque des revendications précédentes, comprenant les étapes suivantes consistant à :
- fournir un élément thermoconducteur (3) pouvant être amené en contact thermique avec la première et la deuxième structure thermorégulable (21, 22) de l'échangeur de chaleur, servant à évacuer ou à amener de la chaleur de ou vers la première et la deuxième structure thermorégulable ;
- sectionner l'élément thermoconducteur en au moins une première, une deuxième et une troisième section (31, 33, 35) électroconductrice ;
- assembler la première section (31) à la deuxième section (33) par l'intermédiaire d'un premier élément d'assemblage (32) constitué d'un premier matériau thermoélectrique ;
- assembler la deuxième section (33) à la troisième section (35) par l'intermédiaire d'un deuxième élément d'assemblage (34) constitué d'un deuxième matériau thermoélectrique, qui est différent du premier matériau thermoélectrique.
